# EUROPÄISCHE PATENTSCHRIFT

(11) **EP 3 592 820 B1**
(45) Veröffentlichungstag und Bekanntmachung des Hinweises auf die Patenterteilung: **26.02.2025**
(21) Anmeldenummer: 18704440.9
(22) Anmeldetag: 24.01.2018
(51) Int. Cl.: C09K 5/00, H01L 23/34, H05K 7/20, B33Y 80/00

(54) **VERBUND AUS KÜHLKÖRPER UND ELEKTRISCHER UND/ODER ELEKTRONISCHER KOMPONENTE**
COMPOSITE OF HEAT SINK AND ELECTRICAL AND/OR ELECTRONIC COMPONENT
COMPOSITE CONSTITUÉ D'UN CORPS DE REFROIDISSEMENT ET D'UN COMPOSANT ÉLECTRIQUE ET/OU ÉLECTRONIQUE

(30) Priorität: 06.03.2017 DE 102017203583
(43) Veröffentlichungstag der Anmeldung: 15.01.2020
(73) Patentinhaber: Siemens Aktiengesellschaft, 80333 München (DE)
(72) Erfinder: EDER, Florian, 91054 Erlangen (DE); MUHRER, Volker, 90768 Fürth (DE); PIHALE, Sven, 91792 Stopfenheim (DE)
(74) Vertreter: Siemens Patent Attorneys
(86) Internationale Anmeldenummer: PCT/EP2018/051699
(87) Internationale Veröffentlichungsnummer: WO 2018/162141

(56) Entgegenhaltungen:
- WO-A2-2007/107601
- DE-A1- 102013 215 255
- DE-A1- 102015 007 791

## Beschreibung

Die Erfindung betrifft elektrische und/oder elektronische Komponenten wie Leistungsschalter und Motoren mit neuartigem Kühlsystem.

Elektrische und elektronische Komponenten wie Leistungsschalter und Motoren erzeugen trotz langjähriger Optimierungsarbeiten Verlustabwärme im Bereich von 1 bis 5 % ihrer Leistungsaufnahme. Wird diese Wärme nicht abgeführt, so sinkt deren Effizienz, deren die Lebenserwartung und/oder Zuverlässigkeit.

Kühlsysteme zur Wärmeabfuhr werden derzeit beispielsweise als vorgefertigte Kühlkörper durch unterschiedliche Montagearten auf die zu entwärmenden Bereiche montiert. Beispielsweise werden Kühlkörper aufgeklebt, wobei günstiger Weise die Kleber noch hinsichtlich ihrer Wärmeleitfähigkeit - beispielsweise durch Einbringen wärmeleitfähiger Partikel - optimiert sind. Andererseits werden Wärmeleitpasten für eine Montage genutzt, allerdings besteht dabei die Gefahr, dass die Wärmeleitpasten regelmäßig auszutauschen sind. DE102015007791A1 offenbart die Fertigung eines Verbunds aus einem Kühlkörpers und einer zu kühlenden Oberfläche einer elektrischen Komponente mittels generativen Fertigungsverfahren (3D Druck).

Die beste Wärmeabfuhr liefern über Sinterverfahren hergestellte thermische Verbindungen. Dabei ist jedoch nachteilig, dass zur Ausbildung der thermischen Ankontaktierung Prozesstemperaturen um die 250°C und mehr erforderlich sind. Diesen Belastungen halten nur wenige elektrische und/oder elektronische Komponenten stand, zumal der mit der zu kühlenden Oberfläche zu verbindende Kühlkörper in der Regel diese hohe Temperatur auch noch über einen gewissen Zeitraum speichert. Trotzdem werden heute keramische Kühlelemente auf leistungselektronischen Schaltungen verbaut, da diese einen verringerten Wärmeübergangswiderstand in Kombination mit einem abgeänderten Gesamtsystemaufbau versprechen. Diese Kühlkörper bedeuten aber einen gesteigerten Fertigungsaufwand von beispielsweise 30 bis 40 € Gesamtkosten je Kühlkörper in elektronischen Leistungsschaltern.

Mit steigender Integrationsdichte und Bauteilminiaturisierung nehmen ebenfalls die Ansprüche an die Wärmeabfuhr der Kühlsysteme zu. Diese werden nur ungenügend durch eine größere Dimensionierung der Kühlelemente und/oder eine Verbesserung der thermischen Ankopplung durch Reduzierung der Zahl an Materialübergängen im Gesamtsystem erfüllt.

Hinzu kommt, dass die Anforderung an die Wärmeabfuhr auch von den Umgebungsbedingungen abhängt. Wird beispielsweise ein Umrichter in der Wüste betrieben, so sind aufwändigere Entwärmungsmaßnahmen zu treffen als bei einer gleicher elektrischen und/oder elektronischen Komponente in Mitteleuropa.

Es besteht daher der Bedarf an einem Massenfertigungs-tauglichen Kühlsystem für einen Verbund aus Kühlkörper und elektrischer und/oder elektronischer Komponente, das trotz Massenfertigung auch leicht abänderbar und/oder anpassbar ist. Diese Aufgabe wird durch den Gegenstand der vorliegenden Anmeldung, wie er in den Ansprüchen und der Beschreibung offenbart ist, gelöst.

Dementsprechend ist Gegenstand der vorliegenden Erfindung ein Verbund aus einem Kühlsystem und einer zu kühlenden Oberfläche einer elektrischen und/oder elektronischen Komponente, erhältlich durch die Ausbildung chemischer Bindungen mittels 3D-Druck, wobei als Druckbett die Oberfläche der elektrischen und/oder elektronischen Komponente oder eine auf dieser Oberfläche bereits durch 3-D-Drucken hergestellte Schicht genutzt wird und als Material zum Verdrucken, das zum Aufbau des Kühlsystems dient, eine organo-metallische Verbindung umfassend zumindest eine reaktive Gruppe ausgewählt aus folgenden Gruppen umfassend: Halogen/Halogenid wie Fluor-, Chlor-, Brom-, Jod-Atom; Pseudohalogen/Pseudohalogenid wie CN-, SCN-Gruppe; Amino-, Amid-, Aldehyd-, Keto-, Carboxy-, Thiol-, Hydroxy-, Acryloxy-, Methacryloxy-, Epoxy-, Isocyanat-, Ester-, Sulfonsäure-, Phosphorsäure-, Vinyl-Gruppe und/oder ein "Wasserglas" eingesetzt werden.

Nach einer vorteilhaften Ausführungsform liegen im Verbundchemische Bindungen in Form von van-der-Waals-Bindungen, ionogenen Bindungen und/oder kovalenten Bindungen vor.

Nach einer vorteilhaften Ausführungsform liegen im Verbund die chemischen Bindungen als polare Bindungen vor, die über polarisierende Halogen-, Schwefel-, Sauerstoff- und/oder Stickstoff-haltige funktionelle Gruppen aufgebaut sind.

Nach einer vorteilhaften Ausführungsform ist der Verbund mittels 3D-Druck erhältlich.

Dabei kann vorgesehen sein, dass das Druckbett die Oberfläche der elektrischen und/oder elektronischen Komponente ist und das Kühlsystem mittels 3D-Druck darauf aufgebaut ist.

Insbesondere handelt es sich um einen Verbund aus einem Kühlsystem, das auf einer zu kühlenden Oberfläche einer elektrischen und/oder elektronischen Komponente angeordnet ist, wobei der Verbund mittels 3D-Druck erhältlich ist, wobei das Druckbett die Oberfläche der elektrischen und/oder elektronischen Komponente ist und das Kühlsystem mittels 3D-Druck darauf aufgebaut ist.

Das zu verdruckende Material zum Aufbau des Kühlsystems umfasst entweder in Form einer organo-metallischen Verbindung zumindest eine reaktive Gruppe ausgewählt aus folgenden Gruppen: Halogen/Halogenid wie Fluor-, Chlor-, Brom-, Jod-Atom; Pseudohalogen/Pseudohalogenid wie CN-, SCN-Gruppe; Amino-, Amid-, Aldehyd-, Keto-, Carboxy-, Thiol-, Hydroxy-, Acryloxy-, Methacryloxy-, Epoxy-, Isocyanat-, Ester-, Sulfonsäure-, Phosphorsäure-, Vinyl-Gruppe, umfasst. Diese Gruppen sind beispielsweise in Form von komplexen Verbindungen mit einem oder mehreren Liganden, die eine oder mehrere der oben genannten Gruppen umfassen, verdruckbar.

Alternativ oder ergänzend umfasst das zu verdruckende Material zum Aufbau des Kühlsystems ein Wasserglas.

Beispiele für geeignete Zentralatome einer komplexen organo-metallischen Verbindung sind Silizium, Aluminium, Zirkonium und/oder Titan.

Alternativ oder ergänzend zu den oben genannten Verbindungen können so genannte "Wassergläser" verdruckt werden, also grundsätzlich flüssige Natrium-/Kaliumsilikate, die durch Verkieselung erstarren.

Insbesondere werden im Sinne der vorliegenden Erfindung auch andere genau wie die oben genannten Wassergläser aufgebaute, flüssige und zur Verkieselung fähige Verbindungen unter dem Begriff "Wasserglas" gefasst. Dabei handelt es sich um Verbindungen, die beispielsweise Silicium-, Zirkonium- und/oder Aluminium-Sauerstoffbindungen wie -Si-O-Si-, -Al-O-Al-, -Si-O-Al-, -Zr-O-Zr-, -Si-O-Zr-, -Zr-O-Al-O-Si-, -Si-O-Al-O-Zr-, sowie weitere beliebige Kombinationen davon umfassen.

Das zu verdruckende Material liegt beispielsweise als Paste und/oder in Form einer Dispersion vor.

Das zu verdruckende Material liegt beispielsweise in Reinform oder im Gemisch mit einem Lösungsmittel vor.

Die verdruckbaren Materialien umfassen wärmeleitfähige Partikel, wie beispielsweise solche auf metallischer und/oder keramischer Basis. Geeignete wärmeleitfähige Partikel sind außer den bekannten metallischen oder keramischen, beispielsweise auf Metalloxiden basierenden Partikeln, auch beispielsweise auch Nitride, wie Bornitrid.

Die Füllstoffe können in einer oder mehreren Fraktion(en) vorliegen, plättchen-, stab- und/oder kugelförmige Partikel umfassend.

Als "Füllstofffraktion" wird vorliegend beispielsweise eine Art an Füllstoff, sei es hinsichtlich der Größe, der Form des Materials und/oder des Aufbaus bezeichnet.

Die Füllstoffe können beschichtet und unbeschichtet, in Form von Core-Shell-Partikel, massiven Partikel und/oder als hohle Partikel, sowie in beliebigen Mischungen davon, vorliegen.

Nach einer vorteilhaften Ausführungsform werden die Materialien in Form von Alumino-silicatischen Hybridmaterialien und/oder Wassergläsern verdruckt.

Insbesondere vorteilhaft hat sich der Einsatz von 1 K- oder 2-K-Systemen beim Verdrucken gezeigt. Das Verdrucken von 2-K-Systemen durch die unten genannten Verfahren ist dem Fachmann bekannt. Beim Verdrucken erstarren und/oder härten die verdruckbaren Materialien, wobei eine Nachhärtung thermisch oder UV-initiiert vorgesehen sein kann.

Beim Verdrucken mittels gängiger 3D-Verfahren wie Fused Deposition Molding (FDM), Fused Filament Fabrication (FFF), Multi Jet Fusion bildet das Material dann entweder mit dem Druckbett oder mit einer unteren, bereits gedruckten Schicht eine chemische Bindung aus, insbesondere entweder eine ionogene, eine van-der Walls-Bindung und/oder eine einfache oder mehrfache kovalente Bindung.

Nach einer vorteilhaften Ausführungsform wird das Druckbett, also die Oberfläche der elektrischen und/oder elektronischen Komponente zur Ausbildung der chemischen Bindung noch vor dem Bedrucken vorbehandelt, beispielsweise gereinigt, aufgeraut und/oder mit einer Haftvermittlungsschicht überzogen.

Durch die Erfindung wird erstmals ein Verbund aus einem Kühlsystem und einer elektrischen und/oder elektronischen Komponente geschaffen, bei dem die Wärmeübertragung durch eine Reduzierung der Materialübergänge optimiert ist, derart, dass der Verbund durch die Ausbildung chemischer Bindungen, insbesondere auch kovalenter Bindungen, verbunden ist. Zur Herstellung des Verbunds können 3D-Druckverfahren eingesetzt werden, wobei die zu kühlende Oberfläche direkt oder indirekt als Druckbett einsetzbar ist.

## Patentansprüche

1. Verbund aus einem Kühlsystem und einer zu kühlenden Oberfläche einer elektrischen und/oder elektronischen Komponente, erhältlich durch die Ausbildung chemischer Bindungen mittels 3D-Druck, wobei als Druckbett die Oberfläche der elektrischen und/oder elektronischen Komponente oder eine auf dieser Oberfläche bereits durch 3-D-Drucken hergestellte Schicht genutzt wird und als Material zum Verdrucken, das zum Aufbau des Kühlsystems dient, eine organo-metallische Verbindung umfassend zumindest eine reaktive Gruppe ausgewählt aus folgenden Gruppen umfassend: Halogen/Halogenid wie Fluor-, Chlor-, Brom-, Jod-Atom; Pseudohalogen/Pseudohalogenid wie CN-, SCN-Gruppe; Amino-, Amid-, Aldehyd-, Keto-, Carboxy-, Thiol-, Hydroxy-, Acryloxy-, Methacryloxy-, Epoxy-, Isocyanat-, Ester-, Sulfonsäure-, Phosphorsäure-, Vinyl-Gruppe und/oder ein "Wasserglas" eingesetzt werden.

2. Verbund nach Anspruch 1, der durch Einsatz eines Fused Deposition Molding Verfahrens erhältlich ist.

3. Verbund nach einem der Ansprüche 1 oder 2, der durch Einsatz eines Fused Filament Fabrication Verfahrens erhältlich ist.

4. Verbund nach einem der vorstehenden Ansprüche, der durch Einsatz eines Multi Jet Fusion Verfahrens erhältlich ist.

5. Verbund nach einem der vorhergehenden Ansprüche, wobei zumindest eine organo-metallische Verbindung in Form einer komplexen Verbindung mit einem oder mehreren Liganden vorliegt.

6. Verbund nach Anspruch 5, wobei die komplexe Verbindung ein Zentralatom, ausgewählt aus der Gruppe folgender möglicher Zentralatome: Silizium, Aluminium, Zirkonium und/oder Titan umfasst.

7. Verbund nach einem der vorhergehenden Ansprüche, wobei zum Aufbau des Verbunds Wassergläser eingesetzt werden, die Silicium -Sauerstoffbindungen umfassen.

8. Verbund nach einem der vorhergehenden Ansprüche, wobei zum Aufbau des Verbunds Wassergläser eingesetzt werden, die Zirkonium-Sauerstoffbindungen umfassen.

9. Verbund nach einem der vorhergehenden Ansprüche, wobei zum Aufbau des Verbunds Wassergläser eingesetzt werden, die Aluminium-Sauerstoffbindungen umfassen.

10. Verbund nach einem der vorhergehenden Ansprüche, wobei zum Aufbau des Verbunds Wassergläser eingesetzt werden, die beliebige Kombinationen aus Zirkonium-, Silizium-, und/oder Aluminium-Sauerstoffbindungen umfassen.

11. Verbund nach einem der vorhergehenden Ansprüche, wobei das Material zum Verdrucken als Paste und/oder in Form einer Dispersion vorliegt.

12. Verbund nach einem der vorhergehenden Ansprüche, wobei das Material zum Verdrucken in Reinform oder im Gemisch mit einem Lösungsmittel vorliegt.

13. Verbund nach einem der vorhergehenden Ansprüche, wobei das Material zum Verdrucken wärmeleitfähige Partikel, wie beispielsweise solche auf metallischer und/oder keramischer Basis, umfasst.

14. Verbund nach Anspruch 13, wobei der Füllstoff in Form einer oder mehreren Größen-, Material-, und/oder Form-Fraktion(en) vorliegt.

15. Verbund nach einem der Ansprüche 13 oder 14, wobei der Füllstoff plättchen-, stab- und/oder kugelförmige Partikel umfasst.

16. Verbund nach einem der Ansprüche 13 bis 15, wobei der Füllstoff in einer Menge von 20 bis 70 Vol%, bezogen auf das Material zum Verdrucken, vorliegt.

## Claims

1. Composite composed of a cooling system and a surface to be cooled that is part of an electrical and/or electronic component, obtainable by the forming of chemical bonds by means of 3D printing, wherein the print bed utilized is the surface of the electrical and/or electronic component or a layer already produced on this surface by 3D printing, and the material used for printing, which serves to construct the cooling system, is an organometallic compound comprising at least one reactive group selected from the following groups: halogen/halide such as fluorine atom, chlorine atom, bromine atom, iodine atom; pseudohalogen/pseudohalide such as CN group, SCN group; amino group, amide group, aldehyde group, keto group, carboxyl group, thiol group, hydroxyl group, acryloyloxy group, methacryloyloxy group, epoxy group, isocyanate group, ester group, sulfo group, phosphoric acid group, vinyl group and/or a "waterglass".

2. Composite according to Claim 1, obtainable by use of a fused deposition moulding method.

3. Composite according to either of Claims 1 or 2, obtainable by use of a fused filament fabrication method.

4. Composite according to any of the preceding claims, obtainable by use of a multijet fusion method.

5. Composite according to any of the preceding claims, wherein at least one organometallic compound is in the form of a complex-type compound with one or more ligands.

6. Composite according to Claim 5, wherein the complex-type compound comprises a central atom selected from the group of the following possible central atoms: silicon, aluminium, zirconium and/or titanium.

7. Composite according to any of the preceding claims, wherein the composite is formed using waterglasses comprising silicon-oxygen bonds.

8. Composite according to any of the preceding claims, wherein the composite is formed using waterglasses comprising zirconium-oxygen bonds.

9. Composite according to any of the preceding claims, wherein the composite is formed using waterglasses comprising aluminium-oxygen bonds.

10. Composite according to any of the preceding claims, wherein the composite is formed using waterglasses comprising any combinations of zirconium-, silicon- and/or aluminium-oxygen bonds.

11. Composite according to any of the preceding claims, wherein the material for printing is in paste form and/or in the form of a dispersion.

12. Composite according to any of the preceding claims, wherein the material for printing is in pure form or in a mixture with a solvent.

13. Composite according to any of the preceding claims, wherein the material for printing comprises thermally conductive particles, for example those that are based on metals and/or ceramics.

14. Composite according to Claim 13, wherein the filler is in the form of one or more size fraction(s), material fraction(s) and/or shape fraction(s).

15. Composite according to either of Claims 13 or 14, wherein the filler comprises particles in platelet form, rod form and/or bead form.

16. Composite according to any of Claims 13 to 15, wherein the filler is present in an amount of 20% to 70% by volume, based on the material to be printed.

## Revendications

1. Composite d'un système de refroidissement et d'une surface à refroidir d'un composant électrique et/ou électronique, pouvant être obtenu par la formation de composés chimiques au moyen d'une impression 3D, dans lequel, en tant que lit d'impression, est utilisée la surface du composant électrique et/ou électronique ou une couche déjà préparée par impression 3D sur cette surface et, en tant que matériau pour l'impression qui sert pour la constitution du système de refroidissement, sont employés un composé organométallique comportant au moins un groupe réactif sélectionné dans les groupes suivants comportant : un halogène/halogénure comme un atome de fluor, de chlore, de brome, d'iode ; un pseudohalogène/pseudohalogénure comme un groupe CN-, SCN- ; un groupe amino, amide, aldéhyde, céto, carboxy, thiol, hydroxy, acryloxy, méthacryloxy, époxy, isocyanate, ester, acide sulfonique, acide phosphorique, vinyle et/ou un « verre soluble ».

2. Composite selon la revendication 1, lequel peut être obtenu par l'emploi d'un procédé « Fused Déposition Molding ».

3. Composite selon l'une des revendications 1 ou 2, lequel peut être obtenu par l'emploi d'un procédé « Fused Filament Fabrication ».

4. Composite selon l'une des revendications précédentes, lequel peut être obtenu par l'emploi d'un procédé « Multi Jet Fusion ».

5. Composite selon l'une des revendications précédentes, dans lequel au moins un composé organométallique se présente sous la forme d'un composé complexe avec un ou plusieurs ligands.

6. Composite selon la revendication 5, dans lequel le composé complexe comporte un atome central, sélectionné dans le groupe d'atomes centraux possibles suivants : le silicium, l'aluminium, le zirconium et/ou le titane.

7. Composite selon l'une des revendications précédentes, dans lequel, pour la constitution du composite, sont employés des verres solubles qui comportent des composés de silicium-oxygène.

8. Composite selon l'une des revendications précédentes, dans lequel, pour la constitution du composite, sont employés des verres solubles qui comportent des composés de zirconium-oxygène.

9. Composite selon l'une des revendications précédentes, dans lequel, pour la constitution du composite, sont employés des verres solubles qui comportent des composés d'aluminium-oxygène.

10. Composite selon l'une des revendications précédentes, dans lequel, pour la constitution du composite, sont employés des verres solubles qui comportent des combinaisons quelconques de composés de zirconium-oxygène, de silicium-oxygène, et/ou d'aluminium-oxygène.

11. Composite selon l'une des revendications précédentes, dans lequel le matériau pour l'impression se présente sous forme de pâte et/ou sous la forme d'une dispersion.

12. Composite selon l'une des revendications précédentes, dans lequel le matériau pour l'impression se présente sous forme pure ou en mélange avec un solvant.

13. Composite selon l'une des revendications précédentes, dans lequel le matériau pour l'impression comporte des particules thermoconductrices, comme par exemple celles à base métallique et/ou céramique.

14. Composite selon la revendication 13, dans lequel la charge se présente sous la forme d'une ou de plusieurs fractions de taille, de matériau, et/ou de forme.

15. Composite selon l'une des revendications 13 ou 14, dans lequel la charge comporte des particules lamellaires, en forme de tiges et/ou sphériques.

16. Composite selon l'une des revendications 13 à 15, dans lequel la charge est présente dans une quantité allant de 20 à 70 % en volume, rapporté au matériau pour l'impression.
